# FASCICULE DE BREVET EUROPEEN

(11) **EP 1 043 832 B1**
(45) Date de publication et mention de la délivrance du brevet: **23.01.2008**
(21) Numéro de dépôt: 00400641.7
(22) Date de dépôt: 09.03.2000
(51) Int. Cl.: H03F 3/45, H03F 3/30, H03F 1/32

(54) **Etage différentiel de sortie d'équipement électronique, qui permet de télé-alimenter un terminal**
Differenzausgangsstufe für elektronische Schaltung die Fernspeisung eines Terminals erlaubt
Differential output stage for electronic equipment for feeding a terminal remotely

(30) Priorité: 08.04.1999 FR 9904387
(43) Date de publication de la demande: 11.10.2000
(73) Titulaire: Alcatel Lucent, 75008 Paris (FR)
(72) Inventeur: Bouzidi, Jean-Pierre, 22300 Lannion (FR)
(74) Mandataire: Sciaux, Edmond

(56) Documents cités:
- EP-A- 0 449 200
- US-A- 4 161 693
- US-A- 5 345 190

## Description

L'invention concerne un étage différentiel de sortie d'équipement électronique, par exemple pour une carte d'abonné téléphonique ou un modem situé dans un central téléphonique. Classiquement, un étage différentiel de sortie d'équipement électronique comporte un transformateur à point milieu. Une tension alternative est appliquée au primaire du transformateur. Une tension d'alimentation continue est appliquée au point milieu du secondaire. Les deux bornes extrêmes du secondaire sont reliées, par une ligne, au terminal à télé-alimenter. Un transformateur a pour inconvénients d'être lourd, encombrant, coûteux, et d'avoir une bande passante très limitée. Ces inconvénients sont particulièrement gênants pour télé-alimenter un modem HDSL (High bit rate Digital Subscriber Line) parce qu'un tel modem nécessite une puissance de 6W, soit, pour une tension de 100V, un courant d'alimentation de 60mA. Cela conduit à augmenter la taille du transformateur pour éviter sa saturation.

La demande de brevet Européen EP 0 449 200 (ALCATEL) décrit un étage différentiel de sortie, sans transformateur. Il comprend deux entrées, deux sorties, et deux voies reliant chacune une entrée à une sortie. Chaque voie comporte un premier amplificateur différentiel pour ajouter à la tension d'entrée de la voie considérée une tension de contre-réaction de l'autre voie sur la voie considérée, et un deuxième amplificateur différentiel pour retrancher la tension de sortie de la voie considérée de la tension de sortie du premier amplificateur différentiel. La tension de sortie du deuxième amplificateur différentiel constitue la tension de contre-réaction de la voie considérée sur l'autre voie.

Cet étage différentiel convient parfaitement lorsqu'il n'est pas nécessaire de télé-alimenter un terminal par un courant continu superposé au courant variable constituant le signal à transmettre. Par contre, il ne convient pas pour télé-alimenter un terminal, tel qu'un poste téléphonique classique.

Le but de l'invention est de proposer un étage différentiel sans transformateur et qui soit capable de télé-alimenter un terminal.

L'objet de l'invention est un étage différentiel de sortie d'équipement électronique, cet étage comportant deux voies reliant chacune une entrée à une sortie; et comportant, sur chacune des voies, un premier moyen pour ajouter à la tension d'entrée de la voie considérée une tension de contre-réaction de l'autre voie sur la voie considérée, et un deuxième moyen fournissant cette tension de contre-réaction de la voie considérée sur l'autre voie ;
**caractérisé** en ce que le second moyen pour fournir la tension de contre-réaction de l'autre voie sur la voie considérée comporte des moyens pour fournir une tension de contre-réaction fonction seulement de la composante alternative de la tension de sortie du premier moyen de la voie considérée ;
et en ce qu'il comporte en outre, respectivement dans chaque voie, des moyens pour additionner une tension continue à la tension de sortie de cette voie.

L'étage ainsi caractérisé permet de télé-alimenter un terminal par une tension continue, tout en lui fournissant un signal alternatif, car la tension de contre-réaction est rendue indépendante de la tension continue de la télé-alimentation, par conséquent la tension de contre-réaction ne peut s'opposer à la fourniture de cette tension de télé-alimentation.

L'invention sera mieux comprise et d'autres caractéristiques apparaîtront à l'aide de la description ci-dessous et des figures l'accompagnant :
- La figure 1 représente le schéma synoptique d'un premier exemple de réalisation de l'étage différentiel selon l'invention.
- La figure 2 représente le schéma synoptique d'un deuxième exemple de réalisation de l'étage différentiel selon l'invention.
- La figure 3 représente le schéma synoptique d'un troisième exemple de réalisation de l'étage différentiel selon l'invention.

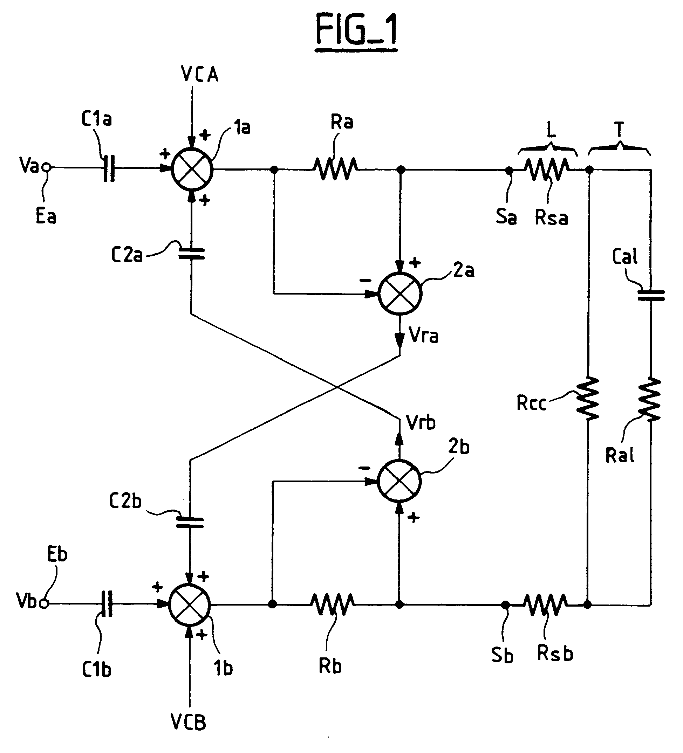

Le premier exemple de réalisation représenté sur la **figure 1** comporte:
- deux bornes d'entrée Ea et Eb recevant respectivement deux tensions variables Va et Vb, constituant un signal différentiel ;
- deux bornes de sorties Sa et Sb, fournissant une tension continue d'alimentation, et un signal alternatif, différentiels, à une ligne L reliée à un terminal distant T.

La ligne L comporte deux conducteurs ayant chacun une certaine résistance. D'autre part, il est prévu une résistance d'adaptation et de protection en série entre la borne de sortie Sa, respectivement Sb, et chacun de ces conducteurs. Les bornes de sorties Sa et Sb voient la ligne L et ces résistances d'adaptation et de protection respectivement comme des résistances Rsa et Rsb. Le terminal distant T est représenté par sa résistance en continu, Rcc, et par sa capacité Cal en série avec une résistance Ral en alternatif. Ce terminal est par exemple un terminal de réseau numérique à intégration de service. Le dispositif selon l'invention peut être relié de manière analogue à un terminal téléphonique analogique classique, un modem télé-alimenté, etc....

Les bornes Ea et Sa sont reliées par une première voie qui comporte :
- un additionneur 1a à trois entrées, recevant respectivement :
   -- une tension continue VCA destinée à télé-alimenter le terminal distant T,
   -- la composante alternative de la tension d'entrée Va, via un condensateur C1a ;
   -- et une tension de contre-réaction via un condensateur C2a ;
- une résistance Ra en série entre la sortie de l'additionneur 1a et la borne de sortie Sa ;
- un soustracteur 2a ayant : une entrée non inversante reliée à la borne de sortie SA , une entrée inversante reliée à la sortie de l'additionneur 1a, et une sortie reliée au condensateur C2b pour lui fournir la tension de contre-réaction.

Les bornes Eb et Sb sont reliées par une seconde voie, symétrique de la première, et qui comporte :
- un additionneur 1 b à trois entrées, recevant respectivement :
   -- une tension continue VCB destinée à télé-alimenter le terminal distant T,
   -- la composante alternative de la tension d'entrée Vb, via un condensateur C1b ;
   -- et une tension de contre-réaction via un condensateur C2b ;
- une résistance Rb en série entre la sortie de l'additionneur 1b et la borne de sortie Sb ;
- un soustracteur 2b ayant : une entrée non inversante reliée à la borne de sortie Sb, une entrée inversante reliée à la sortie de l'additionneur 1 b, et une sortie reliée au condensateur C2a pour lui fournir la tension de contre-réaction.

Cet étage différentiel fournit une tension continue différentielle qui est, à vide, égale à VCA-VCB. Il fournit une tension alternative différentielle qui est, à vide, égale à Va-Vb.

Les additionneurs 1a, 1b et les soustracteurs 2a, 2b sont réalisés de manière classique, au moyen d'amplificateurs opérationnels. Leur résistance de sortie est nulle. L'additionneur 1a et le soustracteur 2a sont alimentés par une première paire d'alimentation fournissant des tensions de 100V et 90V par rapport à un potentiel de référence. L'additionneur 1 b et le soustracteur 2b sont alimentés par une seconde paire d'alimentation fournissant des tensions de 0V et -10V par rapport à un potentiel de référence. Il est ainsi possible de fournir une tension de télé-alimentation de 100V à vide.

Lorsque la ligne et le terminal T sont branchés sur les bornes de sortie Sa, Sb, la tension continue aux bornes du terminal T est fonction : de sa résistance en continu Rcc, de la résistance Rsa+Rsb de la ligne L et des résistances d'adaptation et de protection, et des résistances Ra et Rb de contre-réaction. La tension alternative est fonction de sa résistance en alternatif Ral, de la résistance Rsa+Rsb de la ligne L et des résistances d'adaptation et de protection. Par contre, on démontre que la contre-réaction a pour effet de rendre la tension alternative indépendante de la valeur des résistances Ra et Rb de contre-réaction.

Dans ce premier exemple de réalisation, le courant d'alimentation est fourni entièrement par les additionneurs 1a et 1b. Ils doivent donc être construits pour supporter la puissance dissipée correspondant à cette fonction de télé-alimentation.

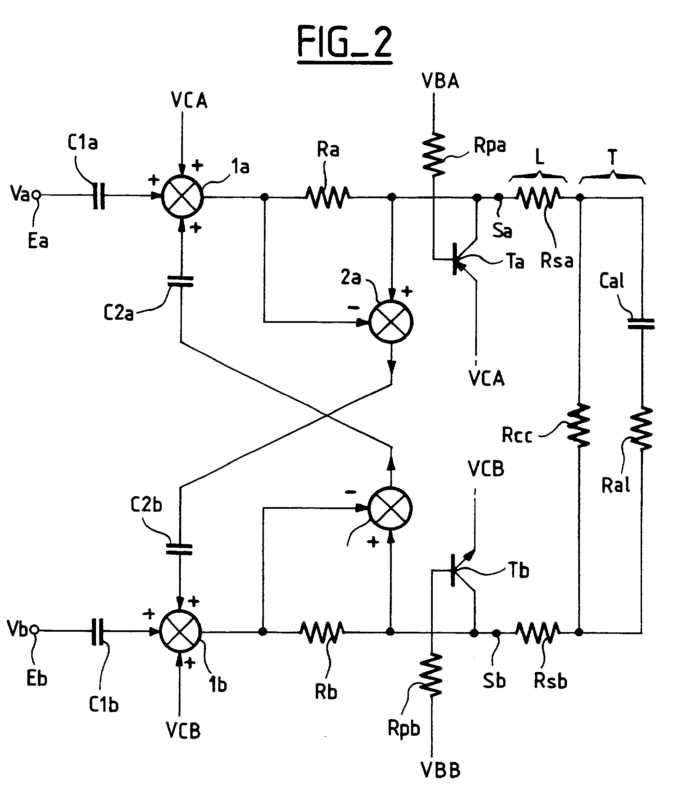

La **figure 2** représente un deuxième exemple de réalisation qui comporte des moyens supplémentaires pour réduire la dissipation supportée par ces additionneurs 1a, 1b. Ces moyens supplémentaires sont :
- un transistor Ta dont le collecteur est relié à la borne de sortie Sa, dont l'émetteur est relié directement à la tension continue d'alimentation VCA, et dont la base est reliée à une tension continue d'alimentation VBA, inférieure à VCA, par une résistance Rpa ;
- et un transistor Tb dont le collecteur est relié à la borne de sortie Sb, dont l'émetteur est relié directement à la tension continue d'alimentation VCB, et dont la base est reliée à la tension continue d'alimentation VBB, supérieure à VCB, par une résistance Rpb.

Les transistors Ta et Tb se comportent comme des générateurs de courant continu qui fournissent respectivement un courant continu supplémentaire à la borne de sortie Sa et un courant continu supplémentaire à la borne de sortie Sb. Ainsi les courants continus à fournir par les additionneurs 1a et 1b sont réduits, et donc la dissipation est réduite dans ces additionneurs.

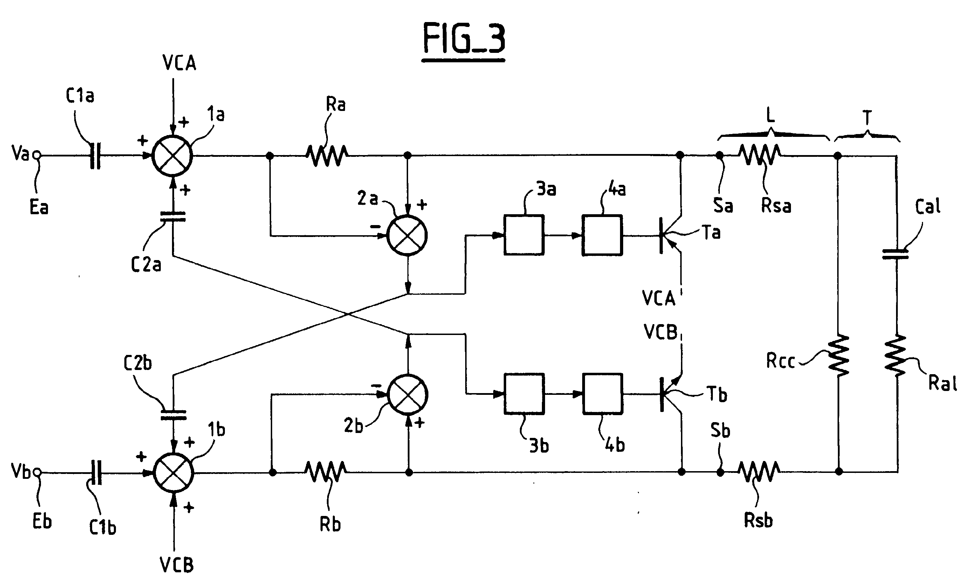

La **figure 3** représente un troisième exemple de réalisation qui comporte des moyens supplémentaires par rapport au deuxième exemple, pour annuler la dissipation supportée par ces additionneurs 1a et 1b, pour la télé-alimentation. Ces moyens supplémentaires sont :
- un filtre passe-bas 3a en série avec un étage amplificateur 4a, qui relient la base du transistor Ta à la sortie du soustracteur 2a, la résistance Rpa étant supprimée ; ce filtre passe-bas 3a et cet étage amplificateur 4a étant alimentés par les mêmes moyens que l'additionneur 1a et le soustracteur 2a ;
- un filtre passe-bas 3b en série avec un étage amplificateur 4b, qui relient la base du transistor Tb à la sortie du soustracteur 2b, la résistance Rpb étant supprimée ; ce filtre passe-bas 3b et cet étage amplificateur 4b étant alimentés par les mêmes moyens que l'additionneur 1b et le soustracteur 2b.

Le filtre passe-bas 3a, respectivement 3b, filtre la tension de contre-réaction fournie par le soustracteur 2a, respectivement 2b, pour ne conserver que la composante continue. Cette composante continue commande le courant de collecteur du transistor Ta, respectivement Tb, de façon à rendre pratiquement nulle la chute de tension aux bornes de la résistance Ra, respectivement Rb. Autrement dit, le courant continu d'alimentation du terminal T est fourni exclusivement par les transistors Ta et Tb. La dissipation dans les additionneurs 1a et 1b est donc réduite au minimum. Par ailleurs, on démontre que la tension d'alimentation du terminal, entre les bornes de sortie Sa et Sb, est constante quelle que soit la valeur Rsa+Rsb de la résistance de la ligne L et des résistances d'adaptation et de protection.

Dans d'autres exemples de réalisation, on peut minimiser les pertes, en continu, en répartissant la résistance Rsa, d'adaptation et de de protection, sous la formes de deux résistances en série placées de part et d'autre du point de connexion du collecteur du transistor Ta. On ferait alors de même pour la résistance Rsb sur l'autre voie.

## Revendications

1. Etage différentiel (1) de sortie d'équipement électronique, cet étage comportant deux voies reliant chacune une entrée (Ea ; Eb) à une sortie (Sa ; Sb) ; et comportant, sur chacune des voies, un premier moyen (1a) pour ajouter à la tension d'entrée de la voie considérée une tension de contre-réaction (Vrb ; Vra) de l'autre voie sur la voie considérée, et un deuxième moyen fournissant cette tension de contre-réaction de la voie considérée sur l'autre voie ;
**caractérisé en ce que** le second moyen pour fournir la tension de contre-réaction de l'autre voie sur la voie considérée comporte des moyens (C2a; C2b) pour fournir une tension de contre-réaction (Vrb ; Vra) fonction seulement de la composante alternative de la tension de sortie (Vsa ; Vsb) du premier moyen (1a ; 1b) de la voie considérée ;
et **en ce qu'**il comporte en outre, respectivement dans chaque voie, des moyens (1a ;1b) pour additionner une tension continue (VCA ; VCB) à la tension de sortie de cette voie.

2. Etage différentiel selon la revendication 1, **caractérisé en ce qu'**il comporte en outre, respectivement dans chaque voie, des moyens (Ta ; Tb) pour additionner un courant continu supplémentaire au courant fourni par le premier moyen (1a ; 1b) de cette voie à la sortie de cette voie.

3. Etage différentiel selon la revendication 2, **caractérisé en ce qu'**il comporte en outre, respectivement pour chaque voie, des moyens (3a, 4a ; 3b, 4b) pour asservir l'intensité du courant supplémentaire en fonction de la composante continue du courant fourni par le premier moyen (1a ; 1b) de cette voie à la sortie de cette voie, de façon à annuler la composante continue du courant fourni par le premier moyen (1a ;1b).

## Claims

1. A differential output stage (1) for electronic equipment, said output stage including two channels and each channel connecting an input (Ea; Eb) to an output (Sa; Sb) and including first means (1 a) for adding to the input voltage of the channel concerned a feedback voltage (Vrb; Vra) from the other channel to the channel concerned and second means supplying said feedback voltage from the channel concerned to the other channel, the output stage being **characterized in that** the second means for supplying the feedback voltage from the other channel to the channel concerned include means (C2a; C2b) for supplying a feedback voltage (Vrb; Vra) which is a function only of the AC component of the output voltage (Vsa; Vsb) of the first means (1a; 1 b) of the channel concerned and **in that** said output stage further includes respective means (1 a; 1 b) in each channel for adding a DC voltage (VCA; VCB) to the output voltage of that channel.

2. A differential stage according to claim 1, **characterized in that** it further includes respective means (Ta; Tb) in each channel for adding an additional direct current to the current supplied by the first means (1a; 1b) of that channel at the output of that channel.

3. A differential stage according to claim 2, **characterized in that** it further includes respective means (3a, 4a; 3b, 4b) for each channel for slaving the additional current to the DC component of the current supplied by the first means (1a; 1 b) of that channel at the output of that channel to cancel the DC component of the current supplied by the first means (1a; 1b).

## Patentansprüche

1. Differenzausgangsstufe (1) für eine elektronische Schaltung, wobei diese Stufe zwei Kanäle einschließt, die jeweils einen Eingang (Ea; Eb) mit einem Ausgang (Sa; Sb) verbinden; und auf jedem dieser Kanäle ein erstes Mittel (1a) enthält, um zur Eingangsspannung des betrachteten Kanals eine Gegenkopplungsspannung (Vrb; Vra) des anderen Kanals auf dem betrachteten Kanal hinzuzufügen, und ein zweites Mittel, das diese Gegenkopplungsspannung des betrachteten Kanals auf dem anderen Kanal liefert;
**dadurch gekennzeichnet, dass** das zweite Mittel zum Liefern der Gegenkopplungsspannung des anderen Kanals auf dem betrachteten Kanal Mittel (C2a; C2b) enthält, um eine Gegenkopplungsspannung (Vrb; Vra) zu liefern, die lediglich abhängig ist von der Wechselspannungskomponente der Ausgangsspannung (Vsa; Vsb) des ersten Mittels (1a; 1b) des betrachteten Kanals;
und **dadurch gekennzeichnet, dass** sie außerdem jeweils auf jedem Kanal Mittel (1a; 1b) einschließt, um eine Gleichspannung (VCA; VCB) zur Ausgangsspannung dieses Kanals hinzuzufügen.

2. Differenzstufe gemäß Anspruch 1, **dadurch gekennzeichnet, dass** sie außerdem jeweils auf jedem Kanal Mittel (Ta; Tb) einschließt, um einen zusätzlichen Gleichstrom zu dem Strom hinzuzufügen, der vom ersten Mittel (1a; 1b) dieses Kanals am Ausgang dieses Kanals geliefert wird.

3. Differenzstufe gemäß Anspruch 2, **dadurch gekennzeichnet, dass** sie außerdem jeweils für jeden Kanal Mittel (3a, 4a; 3b, 4b) einschließt, um die Stärke des zusätzlichen Stroms in Abhängigkeit von der Gleichstromkomponente des Stroms, der vom ersten Mittel (1a; 1b) dieses Kanals am Ausgang dieses Kanals geliefert wird, mit einem Folgeregelungssystem so zu regeln, dass die Gleichstromkomponente des vom ersten Mittel (1a; 1b) gelieferten Stroms annulliert wird.
